# EUROPEAN PATENT APPLICATION

(11) **EP 2 159 860 A2**
(43) Date of publication of application: **03.03.2010**
(21) Application number: 09010932.3
(22) Date of filing: 26.08.2009
(51) Int. Cl.: H01L 51/52

(54) **Organic electroluminescence element and method of manufacturing the same**

(30) Priority: 28.08.2008 JP 2008219438
(71) Applicant: Yamagata Promotional Organization for Industrial Technology, Yamagata-shi Yamagata 990-2473 (JP)
(72) Inventor: Oda, Atsushi, Yamagata-shi Yamagata 990-2473 (JP); Kawai, Takashi, Yamagata-shi Yamagata 990-2473 (JP); Tanaka, Junichi, Yamagata-shi Yamagata 990-2473 (JP)
(74) Representative: HOFFMANN EITLE

(57) **Abstract**

The present invention provides an organic electroluminescence element in which an anode layer 2, a light emitting unit 3, and a cathode layer 4 which each have optical permeability are stacked on a transparent substrate 1, the cathode layer 4 including a first charge generation layer 4a and a cathode 4c. The cathode 4c is formed by way of a facing target sputtering method. Even in the case where a cathode material which has optical permeability is used, the organic electroluminescence element is driven at a low applied voltage, has no angle dependability of an emission spectrum, and has high luminous efficiency.

## Description

### BACKGROUND OF THE INVENTION

### Field of the Invention

The present invention relates to an organic electroluminescence (EL) element which can be used suitably for illumination and has optical permeability and to a method of manufacturing the same.

### Description of the Related Art

Since the organic EL element is a self-luminescence type element which includes an organic compound as a light emitting material and allows luminescence at a high speed, it is suitable for displaying a video image, and it has features that allow an element structure to be simple and a display panel to be thin. Having such outstanding features, the organic EL element is spreading in everyday life as a cellular phone display or a vehicle-mounted display.

Further, in recent years, it has attracted attention as next-generation lighting, taking advantage of the features of thin plane luminescence as described above.

Since one electrode is formed of a reflective electrode made of a metal, the usual organic EL element is arranged such that light is externally extracted in one direction from the electrode opposite to this reflective electrode, and arranged to have a mirror surface.

In such an organic EL element, influence by optical interference within a device is unavoidable due to its structure and it suffers from a disadvantage that the extraction efficiency of the light to the exterior may be reduced and the angle dependability of an emission spectrum may become large, for example. Furthermore, optical absorption in the reflective electrode also reduces the luminous efficiency. In particular, the influence is remarkable in an element having a multi-photon structure.

With respect to this, it has been considered that the organic EL element which is not influenced by optical interference can be prepared by forming the conventional reflective electrode with the transparent electrode and by arranging the light to be extracted by diffusion reflection (for example, see Japanese Patent Application Publication Nos. 2002-231054 and 2007-200597).

However, with the conventional element structure, in the case where the reflective electrode is simply replaced with the transparent electrode, it is difficult to inject electron from the transparent electrode. Further, because of the plasma damage by the sputtering etc. at the time of forming the transparent electrode, it is not possible to obtain an element property equivalent to that using the conventional reflective electrode in the element whose cathode is constituted by the transparent electrode.

Therefore, in the case of using the organic EL element as a light source, such as lighting, especially, there is a need for a technique which allows aiming at improving the efficiency of extracting the light from the organic EL element to the exterior.

### SUMMARY OF THE INVENTION

The present invention arises in order to solve the above-mentioned technical problem, and aims at providing an organic EL (electroluminescence) element and a method of manufacturing the same, in which even in the case where a cathode material having optical permeability is used, it can be driven at a low applied voltage, there is no angle dependability of an emission spectrum, and luminous efficiency is high.

The organic EL element in accordance with the present invention, in which an anode layer, a light emitting unit having at least one light emitting layer, and a cathode layer are stacked on a transparent substrate, is characterized in that the above-mentioned anode layer, the above-mentioned light emitting unit, and the above-mentioned cathode layer all have optical permeability, and the above-mentioned cathode layer has a layer structure including a first charge generation layer, which contains at least an electron accepting substance, and a cathode.

According to such an element structure, it is possible to emit light from both electrode sides, and aim at improving an extraction efficiency of extracting the light to the exterior without requiring a change in designing the light emitting unit.

In the above-mentioned organic EL element, it is preferable that the above-mentioned cathode layer is provided with a metal oxide layer between the above-mentioned first charge generation layer and the above-mentioned cathode.

The above-mentioned metal oxide layer plays the role of a plasma damage reduction layer when forming a transparent electrode.

Since the above-mentioned first charge generation layer prevents the above-mentioned cathode from being high voltage, the cathode may be made of a metal having a work function of 4.0 eV or more.

Further, it is preferable that the above-mentioned metal oxide layer is made of either a molybdenum oxide, a vanadium oxide, or a tungstic oxide.

The above-mentioned organic EL element may be such that a plurality of the above-mentioned light emitting units are stacked in series through the second charge generation layer to provide a multi-photon structure.

Furthermore, it is preferable that the light is extracted from either the above-mentioned anode layer side or the above-mentioned cathode layer side, and an optical diffusion reflection layer is provided outside the cathode layer or the anode layer which is located on the opposite side of this light extraction side.

Since this optical diffusion reflection layer is provided, it is possible to avoid the angle dependability, and to improve the optical extraction efficiency, even if the design of the composition material of each layer of the light emitting unit is not changed. Further, it is possible to minimize the film thickness of each layer of the light emitting unit and to aim at reducing the voltage.

Furthermore, the method of manufacturing the organic EL element in accordance with the present invention is characterized by forming the cathode of the above-mentioned cathode layer by way of a facing target sputtering method when manufacturing the above-mentioned organic EL element.

According to the facing target sputtering method, it is possible to reduce the plasma damage to the organic layer of the light emitting unit.

Even in the case where the cathode material having the optical permeability is used, the organic EL element in accordance with the present invention can be driven at a low applied voltage, the angle dependability of the emission spectrum is controlled, and it is possible to aim at improving the extraction efficiency of extracting the light to the exterior.

Further, according to the manufacture method in accordance with the present invention, the organic EL element having the optical permeability can be produced, without damaging the organic layer etc. when forming the electrode, even if the composition material of the light emitting unit including the light emitting layer is not redesigned.

Therefore, as for the organic EL element in accordance with the present invention, it is possible to utilize the property as a plane light emitter excellent in high color rendering properties, not only in the conventional display use but also in light source uses, such as illumination.

### BRIEF DESCRIPTION OF THE DRAWINGS

FIG. 1 is a sectional view schematically showing a layer structure of an organic EL element in accordance with the present invention.
FIG. 2 is a graph of results of evaluating angle dependability of spectra of the organic EL element in accordance with Comparative Example 2.
FIG. 3 is a graph of results of evaluating angle dependability of spectra of the organic EL element in accordance with Example 2.
FIG. 4 is a graph of results of evaluating angle dependability of spectra of the organic EL element in accordance with Example 3.
FIG. 5 is a graph of results of evaluating angle dependability of spectra of the organic EL element in accordance with Comparative Example 3.
FIG. 6 is a graph of results of evaluating of luminous flux densities (integral spectra) of the spectra of the organic elements in accordance with Examples 3 and 4.

### DESCRIPTION OF THE PREFERRED ENBODIMENTS

Hereafter, the present invention will be described in detail with reference to the drawings.

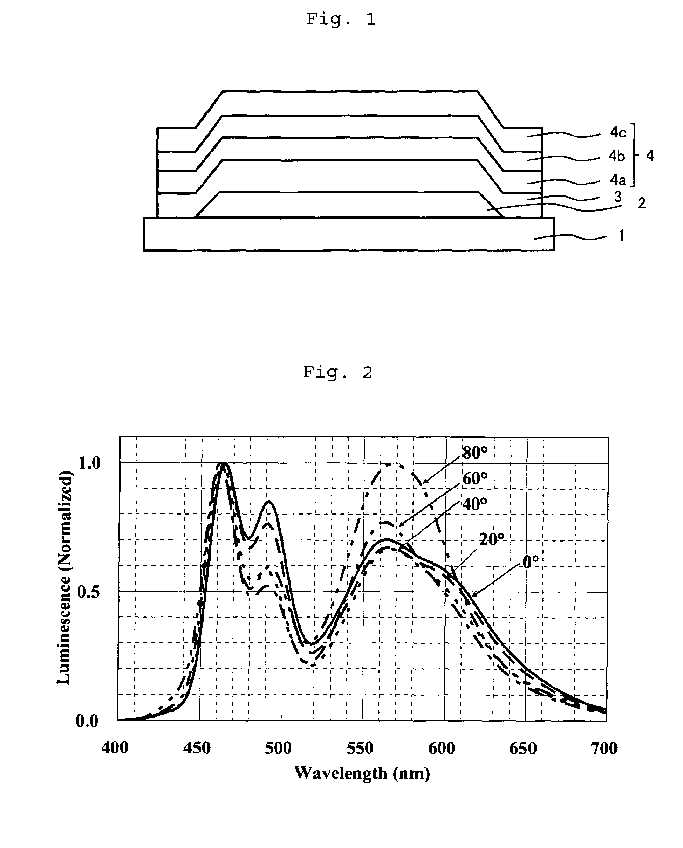

An example of a layer structure of an organic EL element in accordance with the present invention is shown in FIG. 1. The organic EL element as shown in FIG. 1 is an organic EL element in which an anode layer 2, a light emitting unit 3 having at least one light emitting layer, and a cathode layer 4 are stacked on a transparent substrate 1.

Further, the above-mentioned anode layer 2, the above-mentioned light emitting unit 3, and the above-mentioned cathode layers 4 all have optical permeability. In other words, the light emitted at the light emitting unit 3 can be extracted from both an anode layer 2 side and a cathode layer 4 side.

Furthermore, the above-mentioned cathode layer 4 has a layer structure including a first charge generation layer 4a, which contains at least an electron accepting substance, and a cathode 4c.

The above-mentioned anode layer 2 is formed of an electrode material having a high work function (4.0 eV or more), as a transparent electrode on the transparent substrate 1.

Such a transparent electrode can also be formed of thin films made of metals (gold, silver, nickel, palladium, platinum, etc.). However, metal oxides (such as indium tin oxide (ITO), indium zinc oxide, zinc oxide, etc.) are used generally. In particular, ITO is suitably used in terms of transparency, conductivity, etc.

Although the film thickness of this transparent electrode changes with degrees of the required optical permeability, it is usually preferable that transmissivity of visible light is 60 % or more. More preferably, it is 80 % or more. In order to secure such optical permeability and conductivity, the film thickness is usually set to 5-1000 nm. Preferably, it is approximately 10-500 nm.

It is preferable that the anode is usually formed by a CVD method, a sputtering method, a vacuum deposition method, etc., and formed as a transparent conductive thin film.

In the organic EL element in accordance with the present invention, the cathode 4c which constitutes the above-mentioned cathode layer 4 is also formed as a transparent electrode similar to the above-mentioned anode layer 2.

In a usual bottom emission element, the above-mentioned cathode 4c is constituted by metals having a low (4.0 eV or less) work function, such as aluminum, an aluminum-lithium alloy, and a magnesium silver alloy, an alloy, and a conductive compound. In the present invention, however, an electrode material with a higher (4.0 eV or more) work function than that of a metal for such a conventional electrode material etc. is used for providing a transparent electrode.

For this reason, as for the conventional layer structure, an injection barrier is formed at a boundary between the cathode and the light emitting unit, and it is difficult for the above-mentioned transparent electrodes to inject electrons from the cathode 4c. Thus, in the present invention, the above-mentioned charge generation layer 4a is inserted and carriers are injected from this charge generation layer 4a to prevent a high voltage.

In addition, in the present invention, in the case where the charge generation layer 4a which constitutes a cathode layer 4 is distinguished from a charge generation layer (second charge generation layer) interposed between the light emitting units of a multi-photon structure, it may be referred to as a first charge generation layer.

The above-mentioned charge generation layer 4a may contain at least an electron accepting substance. Further, it may contain an electron supply substance. For example, it is possible to employ such a structure as disclosed in Japanese Patent No. 3933591. The same applies to the second charge generation layer.

Furthermore, the above-mentioned electron accepting substance and the electron supply substance may each be a single compound, or may each be a mixture.

The overall film thickness of this charge generation layer 4a is usually between 1 nm and 200 nm (inclusive), and preferably between 5 nm and 100 nm (inclusive).

In addition, in the case of forming a film of the cathode 4c by metal oxides, such as the above-mentioned ITO etc., the substrate is exposed to a high temperature by the CVD method or the vacuum deposition method. It therefore follows that the light emitting unit 3 or the charge generation layer 4a, made of an organic material, of the above-mentioned cathode layer 4 is damaged. In an ion-plating method, the damage to the light emitting unit 3 etc. is also considerable due to ion bombardment. Further, also in sputtering methods, such as a usual reactive sputtering method and a usual magnetron sputtering method, charged particles (electron, ion) and radical oxygen resulting from electric discharge may be generated to damage the light emitting unit 3 already formed on the substrate or the charge generation layer 4b, made of an organic material, of the above-mentioned cathode layer 4, and thus the organic EL element is caused to have a high voltage.

For this reason, it is preferable that the film formation of the cathode 4c on the substrate in which the light emitting unit 3 etc. is already formed is carried out by a facing target sputtering method in order to reduce such damage by heat, plasma, etc. as describe above. Furthermore, in the case where the above-mentioned cathode 4c is formed by the facing target sputtering method, it is preferable to form a metal oxide layer 4b as a damage reduction layer on the above-mentioned light emitting unit 3 etc. in order to prevent the plasma damage to the light emitting unit 3 or the charge generation layer 4a, made of an organic material, of the above-mentioned cathode layer 4.

As for the metal oxide layer 6 which plays the role of such a sputtering damage reduction layer, it is preferable to be formed of, for example, a molybdenum oxide, a vanadium oxide, a tungstic oxide, etc. As particular examples, there may be mentioned molybdenum trioxide (MoO₃), vanadium pentoxide (V₂O₅), etc.

If the film thickness of this metal oxide layer 4b provides effects as the above-mentioned sputtering buffer layers, then it will suffice. It is preferably as thin as possible in terms of securing optical permeability, more preferably between 1 nm and 100 nm (inclusive).

Of the structural elements of the organic EL element in accordance with the present invention, the transparent substrate 1 serves as a support member for the organic EL element and as a luminescence side, thus its optical transmissivity is preferably 80% or more, and more preferably 90% or more.

In general, the above-mentioned transparent substrate employs glass substrates made of, such as for example, optical glass (BK7, BaK1, F2, etc.), silica glass, non alkali glass, borosilicate glass, aluminosilicate glass, polymer substrates made of, such as for example, acrylic resins (PMMA, etc.), polycarbonate, polyether sulphonate, polystyrene, polyolefin, an epoxy resin, and polyester (polyethylene terephthalate, etc.), etc.

Although the above-mentioned substrate having a thickness of approximately 0.1-10 mm is usually used, it is preferable that the thickness is 0.3-5 mm in view of mechanical strength, weight, etc. More preferably it is 0.5-2 mm.

Further, the light emitting unit 3 in the organic EL element in accordance with the present invention may only have at least one light emitting layer, and may be of a single layer or multiple layers. Still further, it may have a layer structure of a conventional organic EL element. As particular examples of the layer structure, there may be mentioned structures of "light emitting layer only", "hole transport layer / light emitting layer", "light emitting layer / electron transport layer", "hole transport layer / light emitting layer / electron transport layer", etc.

Furthermore, it may employ the conventional laminate structure including a hole injection layer, a hole transport light emitting layer, a hole inhibition layer, an electron injection layer, an electron transport light emitting layer, etc.

The material that constitutes each layer of the above-mentioned light emitting unit 3 is not particularly limited and a conventional one can be used. Further, it may be either a low molecular weight material or a high molecular weight material.

The formation of each of these layers can be performed by way of dry processes, such as a vacuum deposition process, a sputtering process, etc., and wet processes, such as an ink-jet process, a casting process, a dip coat process, a bar coat process, a blade coat process, a roll coat process, a photogravure coat process, a flexographic printing process, a spray coat process, etc. Preferably, the film formation is carried out by vacuum deposition.

Further, although a film thickness of each of the above-mentioned layers is suitably determined depending on its conditions in view of adaptability between the respective layers, the overall layer thickness to be required, etc., it is usually preferable to be within a range from 5 nm to 5 micrometers.

As described above, in the present invention, it is not necessary to redesign newly the layer structure and constituent materials of the light emitting unit, and it is possible to employ a conventional element structure and a conventional formation method.

It is also possible to apply the above-mentioned organic EL element to a multi-photon structure in which a plurality of the above-mentioned light emitting units are connected in series through the second charge generation layer.

As for a mirror surface element provided with a reflective electrode, it is influenced by optical interference and has a limit in the quantity of light which can be extracted. In particular, the influence is remarkable in the multi-photon structure.

On the other hand, by combining a transparent element and an optical diffusion reflection layer of the multi-photon structure, it is possible to control the influence of the optical interference more greatly and to attain an organic EL element which is highly efficient and has a longer operating life.

Further, as for the above-mentioned organic EL element, the optical diffusion reflection layer may be provided for the outside of either the anode layer 2 or the cathode layer 4.

As the above-mentioned optical diffusion reflection layer is provided, it is arranged that light is extracted from either the above-mentioned anode layer 2 side or the above-mentioned cathode layer 4 side. Then, it is possible to minimize the film thickness of each layer of the light emitting unit which is required for extracting the light and to reduce the voltage. Further, it follows that a spectrum does not depend on an angle, thus aiming at improving the light extraction efficiency.

It is preferable that the above-mentioned optical diffusion reflection layer is provided in direct contact with the above-mentioned anode layer 2 (or cathode layer 4).

Between both layers, if there is an air layer or a sealing member of a resin etc. having a refractive index lower than that of the above-mentioned anode layer 2 (or cathode layer 4), then of the light emitted in the light emitting unit, most of the total reflection component generated due to a refractive-index difference between the above-mentioned anode layer 2 (or cathode layer 4) and the sealing member or air may not be taken out.

For this reason, in terms of improving the extraction efficiency of light, it is preferable to directly stack the anode layer 2 (or cathode layer 4) and the optical diffusion reflection layer having a high refractive index in order to reduce losses in the light incident to the optical diffusion reflection layer.

The above-mentioned optical diffusion reflection layer can be formed by applying simple substance particles, such as titanium oxide, aluminumoxide, barium sulfate, zeolite, etc. , or a liquid, a resin, a gel, etc. in which a mixture of these particles is dispersed.

An organic EL element panel can be produced by vacuumbonding a substrate in which such an optical diffusion reflection layer is applied or printed to the remaining element structure part of the organic EL element.

If the above-mentioned optical diffusion reflection layer is so thick as to provide effects of diffusing and reflecting the light, then it will suffice. It is preferably between 1 micrometers and 1 mm (inclusive).

Hereafter, the present invention will be described more particularly with reference to Examples, but the present invention is not limited to the following Examples.

### [Example 1]

An organic electroluminescence transparent element having a layer structure as shown in FIG. 1 was prepared by the following method.

### (Transparent Substrate 1 and Anode Layer 2)

First, a glass substrate having formed thereon a patterned transparent electroconductive film (ITO) with a film thickness of 300 nm was subjected to washing treatments in the order of ultrasonic cleaning by pure water and a surfactant, washing with flowing pure water, ultrasonic cleaning by a 1:1 mixed solution of pure water and isopropyl alcohol, and boiling washing by isopropyl alcohol. This substrate was slowly pulled up from the boiling isopropyl alcohol, and dried in isopropyl alcohol vapor, and, finally ultraviolet ozone cleaning was performed.

This substrate was used as an anode 1 and placed in a vacuum chamber which was evacuated to 1×10⁻⁶ Torr. In this vacuum chamber, each molybdenum boat filled up with a vapor deposition material and a vapor deposition mask for forming a film in a predetermined pattern were placed, the above-mentioned boat was electrically heated, and the vapor deposition material was evaporated to thereby form a light emitting unit 3, a charge generation layer 4a of a cathode layer 4, and a metal oxide layer 6 one by one.

### (Light Emitting Unit 3)

On the above-mentioned substrate, a molybdenum trioxide (MoO₃) film was formed to have a film thickness of 5 nm, and a hole injection layer was formed.

Next, using NS-21 (manufactured by Nippon Steel Chemical Co., Ltd.) as a hole transport material, the respective boats and MoO₃ were electrically heated at the same time to carry out co-deposition. NS21:MoO₃ = 90:10 were subjected to film formation to have a film thickness of 20 nm. Further, NS21 was subjected to film formation to have a film thickness of 5 nm and the hole transport layer was formed.

Then, the light emitting layer was formed in such a way thatNS21:EY52(manufactured by e-Ray OptoelectronicsTechnology (hereafter referred to as e-Ray)) = 98.7:1.3 were subjected to film formation to have a film thickness of 20 nm, and further, EB43(manufactured by e-Ray):EB52(manufactured by e-Ray) = 98.8:1.2were subjected to film formation to have a film thickness of 30 nm, so as to be a white light emitting element.

On the above-mentioned light emitting layer, bis(2-methyl-8-quinolinolato)(p-phenylphenolato)aluminum (BAlq) was subjected to film formation to have a film thickness of 5 nm, thus forming a hole inhibition layer.

### (Cathode Layer 4)

Using Liq as an electron supply substance, DPB:Liq = 75:25 were subjected to film formation to have a film thickness of 35 nm, on which an aluminum (Al) film was formed to have a film thickness of 1.5 nm, and further, NS21:MoO₃ = 75:25 were subjected to film formation to have a film thickness of 10 nm by using MoO₃ as an electron accepting substance, thus forming a charge generation layer 4a.

On the layer, a MoO₃ film was formed as a metal oxide layer 4b to have a film thickness of 5 nm.

An ITO film was formed as the cathode 4c to have a film thickness of 100 nm by a facing target sputtering method.

This was sealed with another glass plate using a UV curing resin, and a transparent element was obtained.

A layer structure of this element may be simplified and shown as being ITO (300 nm) / MoO₃ (5 nm) / NS21:MoO₃ (10 nm, 90:10) / NS21(5 nm) / NS21:EY52(20 nm, 98.7:1.3) / EB43:EB52(30 nm, 98.8:1.2) / BAlq(5 nm) / DPB:Liq(35 nm, 75:25) / Al(1.5 nm) / NS21:MoO₃(10 nm, 75:25) / MoO₃(5 nm) / ITO(100 nm).

### [Comparative Example 1]

A bottom emission element having a conventional mirror surface structure provided with a reflective electrode Al was prepared.

In Example 1, the charge generation layer of a cathode layer was made only of DPB:Liq(35nm, 75:25) without forming a metal oxide layer. While maintaining the vacuum chamber at a vacuum, masks were replaced to install masks for cathode vapor deposition. An aluminum (Al) layer was formed having a film thickness of 60 nm to be a cathode.

Except for this, a mirror surface element was prepared similarly to Example 1.

A layer structure of this element may be simplified and shown as being ITO (300 nm) / MoO₃ (5 nm) / NS21:MoO₃ (10 nm, 90:10) / NS21(5 nm) / NS21:EY52(20 nm, 98.7:1.3) / EB43:EB52 (30 nm, 98.8:1.2) / BAlq(5 nm) / DPB:Liq (35 nm, 75:25) / Al (60 nm).

### [Comparative Example 2]

The transparent electrode ITO (100 nm) in Example 1 was replaced with the reflective electrode Al (60 nm). Except for this, the mirror surface element was prepared similarly to Example 1.

A layer structure of this element may be simplified and shown as being ITO(300 nm) / MoO₃(5 nm) / NS21:MoO3(10 nm, 90:10) / NS21(5 nm) / NS21:EY52(20 nm, 98.7:1.3) / EB43:EB52(30 nm, 98.8:1.2) / BAlq(5 nm) / DPB:Liq(35 nm, 75:25)/Al(1.5 nm) / NS21:MoO₃(10 nm, 75:25) / MoO₃(5 nm) / Al (60 nm).

FIG. 2 shows a graph of the result of evaluating angle dependability of a spectrum of this element.

As for voltages of respective elements at a current density of 100 A/m², it was 3.7 V in the element of Example 1, it was 3.8 V in the element of Comparative Example 1, and it 1 was 3.4 V in the element of Comparative Example 2.

Thus, as for the transparent element, it is confirmed that an element structure of Example 1 provides a transparent element in which the voltage is prevented from rising similarly to the conventional mirror surface element.

### [Example 2]

Onto ITO (100 nm) of the cathode layer of the transparent element prepared in Example 1, one where titanium oxide (manufactured by Kanto Chemical Co. Inc.: anatase-type; 0.1-0.3 micrometers in particle size) and fluorinated oil (demnum S-20, manufactured by Daikin Industries, Ltd.) were dewatered, mixed, and defoamed at a low dew point was applied directly, to form an optical diffusion reflection layer having a film thickness of 200 micrometers.

This was sealed with another glass plate using an UV curing resin, to obtain an organic EL element.

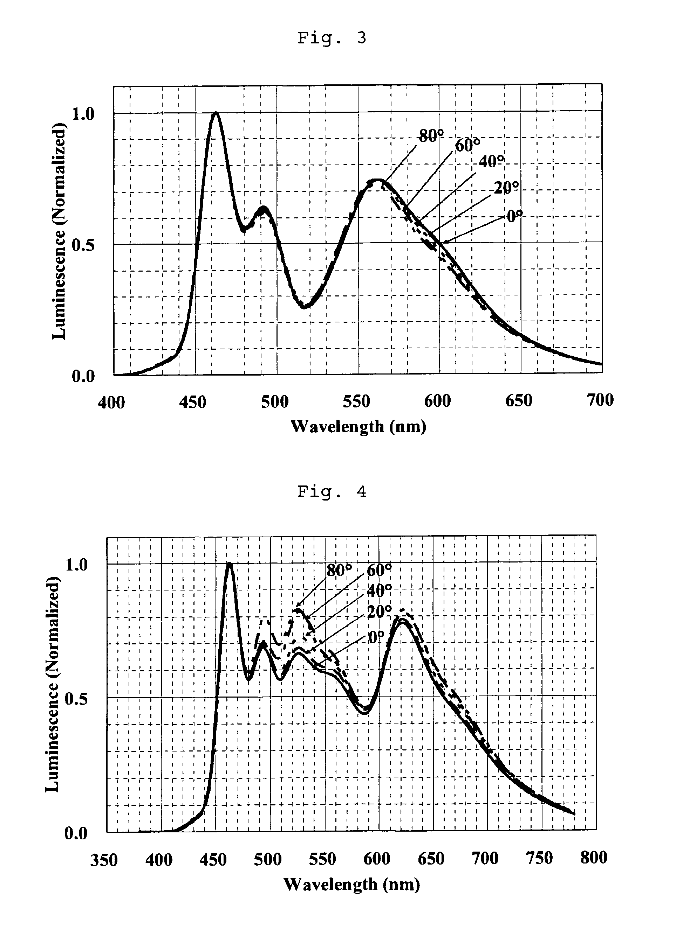

FIG. 3 shows a graph of the result of evaluating angle dependability of a spectrum of this element.

As is clear from comparison between FIGS. 2 and 3, in the case where the optical diffusion reflection layer is prepared, it is confirmed that the angle dependability of the spectrum is controlled and it looks the same in color at any angle (in Example 2, FIG. 2),

Further, external quantum efficiency at a current density of 100 A/m² was 4.4 % with the mirror surface element (Comparative Example 2), while it was 5.0 % in the case where the optical diffusion reflection layer was formed at the transparent element (Example 2). Thus, it is confirmed that the efficiency with which the light is outwardly extracted is improved.

### [Example 3]

By way of a technique similar to that in Example 1, each electrode layer and a light emitting unit were formed to laminate four light emitting units through a second charge generation layer. Further, the optical diffusion reflection layer was formed by way of a technique similar to that in Example 2, to prepare the organic EL element of a multi-photon structure.

The above-mentioned second charge generation layer was such that, using Liq as the electron supply substance, DPB:Liq = 75:25 were subjected to film formation to have a film thickness of 17 nm, on which an aluminum (Al) film having a film thickness of 0.5 nm was formed. Further, MoO₃, as an electron accepting substance, was subjected to film formation independently to have a film thickness of 2 nm and formed between the respective units.

A layer structure of this element is simplified and shown ITO(300 nm) / MoO₃(5 nm) // first unit (blue) [NS21(15 nm) / EB43:EB52 (30nm, 98.8:1.2) /BAlq(5nm)] // DPB:Liq(17 nm, 75:25) / Al(0.5 nm) / MoO₃(2 nm) / / second unit (yellow + blue) [NS21(15 nm) / NS21:EY52(20 nm, 98.7:1.3) / EB43:EB52(30 nm, 98.8:1.2)/BAlq (5nm)] // DPB:Liq(17 nm, 75:25) / Al(0.5 nm) / MoO₃(2 nm) // third unit (green) [NS21 (15 nm) / Alq₃:C545t (30 nm, 98.5:1.5) / BAlq (5 nm)] /DPB:Liq(17 nm, 75:25) / Al(0.5 nm) / MoO₃(2 nm) // fourth unit (red) [NS21(15 nm) / BAlq:Ir(piq)₃ (30 nm, 90:10)] // DPB:Liq(17 nm, 75:25) / Al(0.5 nm) / MoO₃(5 nm) / ITO(100 nm) / optical diffusion reflection layer (200 micrometers).

FIG. 4 shows a graph of the result of evaluating angle dependability of a spectrum of this element.

### [Comparative Example 3]

The charge generation layer of the cathode layer of Example 3 was made only of DPB:Liq (17 nm, 75:25) without forming a metal oxide layer. The transparent electrode ITO (100 nm) was replaced with the reflective electrode Al (60 nm) to form the cathode. Except for this, the mirror surface element having a multi-photon structure provided with four light emitting units was prepared similarly to Example 3.

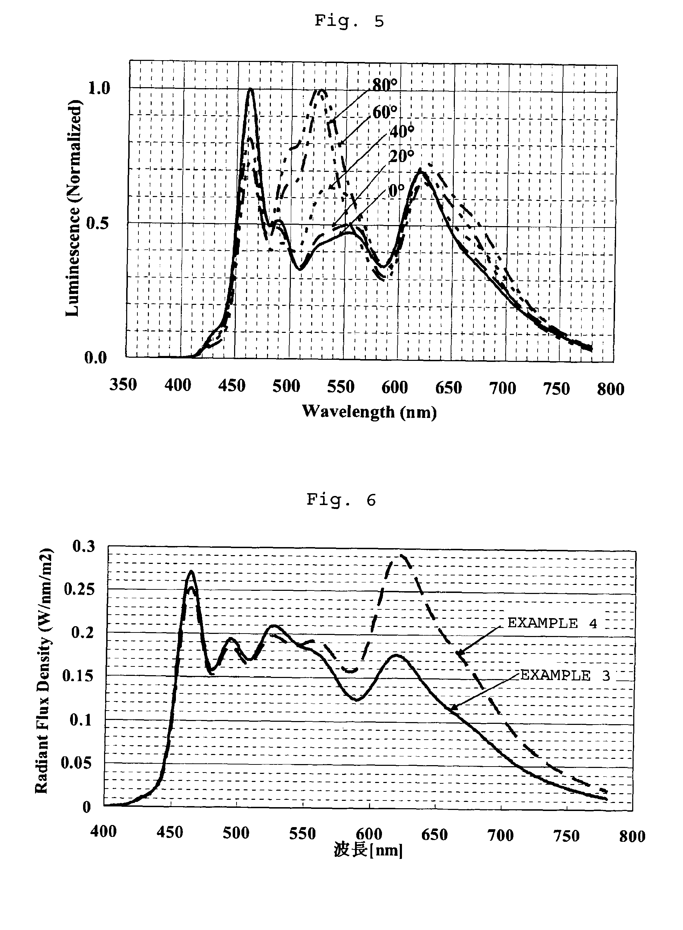

FIG. 5 shows a graph of the result of evaluating angle dependability of a spectrum of this element.

Table 1 shows the evaluation result of the external quantum efficiency at a current density of 100 A/m² with respect to the elements of the multi-photon structure in Example 3 and Comparative Example 3 above, and the elements provided with the optical diffusion reflection layer prepared for each unit.

**[Table 1]**

| Element Structure | External Quantum Efficiency(%) (Current Density 100 A/M²) |
|---|---|
| Example 3 | 19.0 |
| Comparative Example 3 | 11.3 |
| First Unit | 8.6 |
| Second Unit | 3.6 |
| Third Unit | 5.4 |
| Fourth Unit | 4.2 |

As shown in Table 1, in the case where the optical diffusion reflection layer is formed at the transparent element having the multi-photon structure (Example 3), it is confirmed that the external quantum efficiency is substantially a multiple of the number of the light emitting units (sum of all units).

Further, as is clear from comparison between FIGS. 4 and 5, in the case where the optical diffusion reflection layer is prepared (Example 3, FIG. 4), it is confirmed that the angle dependability of the spectrum is controlled.

### [Example 4]

The layer stack order of the first - the fourth units of the light emitting units in Example 3 was reversed, the stacking started with the fourth unit. Except for this, an element having a multi-photon structure provided with four light emitting units was prepared similarly to Example 3.

FIG. 6 shows a graph of the result of evaluating a luminous flux density of a spectrum (integral spectrum) of this element together with that of Example 3.

The external quantum efficiency of this element at a current density of 100 A/m² is 25.1 %, and it is confirmed that it is higher than that of the element of Example 3.

Further, as is clear from FIG. 6, in the case where the light emitting units of Example 3 are stacked in the reverse order (Example 4), it is confirmed that a light-extraction amount is large especially in a long wavelength component. This is because the light-extraction amount depends on a distance between the respective light emitting units which emit light different in wavelength from that of the optical diffusion reflection layer, and it is considered to be based on a so-called cavity effect.

## Claims

1. An organic electroluminescence element in which an anode layer, a light emitting unit having at least one light emitting layer, and a cathode layer are stacked on a transparent substrate, wherein
said anode layer, said light emitting unit, and said cathode layer all have optical permeability, and
said cathode layer has a laminate structure including a first charge generation layer, which contains at least an electron accepting substance, and a cathode.

2. The organic electroluminescence element as claimed in claim 1, wherein said cathode layer is provided with a metal oxide layer between said first charge generation layer and said cathode.

3. The organic electroluminescence element as claimed in claim 1 or 2, wherein said cathode is made of a metal having a work function of 4.0 eV or more.

4. The organic electroluminescence element as claimed in claim 2, wherein said metal oxide layer is made of either a molybdenum oxide, a vanadium oxide, or a tungstic oxide.

5. The organic electroluminescence element as claimed in claim 1, wherein a plurality of said light emitting units are connected in series through the second charge generation layer to provide a multi-photon structure.

6. The organic electroluminescence element as claimed in claim 1, wherein light is extracted from either said anode layer side or said cathode layer side, and an optical diffusion reflection layer is provided outside the cathode layer or the anode layer which is located on the opposite side of said light extraction side.

7. A method of manufacturing an organic electroluminescence element according to a method of manufacturing the organic electroluminescence element as recited in claim 1, wherein the cathode of said cathode layer is formed by way of a facing target sputtering method.
